# EUROPÄISCHE PATENTANMELDUNG

(11) **EP 2 613 319 A1**
(43) Veröffentlichungstag der Anmeldung: **10.07.2013**
(21) Anmeldenummer: 12150277.7
(22) Anmeldetag: 05.01.2012
(51) Int. Cl.: G11B 7/245, G11B 7/24, G03F 7/00

(54) **Schichtverbund aus einem Photopolymerfilm und einer Klebstoffschicht**

(71) Anmelder: Bayer MaterialScience AG, 51373 Leverkusen (DE)
(72) Erfinder: Die Erfindernennung liegt noch nicht vor

(57) **Zusammenfassung**

Die vorliegende Erfindung betrifft einen Schichtverbund umfassend einen belichteten Photopolymerfilm und eine zumindest bereichsweise mit dem Photopolymerfilm verbundene Klebstoffschicht, wobei der Photopolymerfilm vernetzte Polyurethan-Matrixpolymere A), vernetzte Schreibmonomere B) und ein monomeres Fluorurethan-Additiv C) umfasst, wobei die Klebstoffschicht als Diffusionsbarriere für das Fluorurethan-Additiv C) ausgebildet ist. Ein weiterer Gegenstand der Erfindung ist die Verwendung des Schichtverbunds zur Herstellung von Chipkarten, Ausweisdokumenten oder 3D-Bildern, als Produktschutzetikett, als Label, in Banknoten in Form eines Streifens oder Fensters oder als holografisch optische Elemente in Displays.

## Beschreibung

Die vorliegende Erfindung betrifft einen Schichtverbund umfassend einen belichteten Photopolymerfilm und eine zumindest bereichsweise mit dem Photopolymerfilm verbundene Klebstoffschicht, wobei der Photopolymerfilm vernetzte Polyurethan-Matrixpolymere A), vernetzte Schreibmonomere B) und ein monomeres Fluorurethan-Additiv C) umfasst. Ein weiterer Gegenstand der Erfindung ist die Verwendung des Schichtverbunds zur Herstellung von Chipkarten, Ausweisdokumenten oder 3D-Bildern, als Produktschutzetikett, als Label, in Banknoten in Form eines Streifens oder Fensters oder als holografisch optische Elemente in Displays.

Photopolymerfilme der eingangs genannten Art zur Herstellung holographischer Medien sind aus der WO 2011/054797 und der WO 2011/067057 bekannt. Vorteile dieser holografischen Medien ist deren hohe diffraktive Lichtbeugungseffizienz und das keine Nachprozessierungsschritte nach der holografischen Belichtung wie z.B. chemische oder thermische Entwicklungschritte nötig sind.

Die belichteten Photopolymerfilme werden in vielen Fällen in komplexere Produkte wie Chipkarten oder Ausweisdokumente integriert. Typischerweise wird dazu der Photopolymerfilm mit einem Substrat verklebt. Dabei kann entweder eine flüssigen Klebstoffformulierung oder eine Klebefolie verwendet werden.

Bei Experimenten wurde allerdings festgestellt, dass eine Vielzahl der am Markt verfügbaren Klebefolien und Klebstoffformulierungen im Hologramm einen Farbshift erzeugen, wenn sie mit den oben genannten belichteten Photopolymerfilmen in Kontakt gebracht werden. Besonders bei RGB-Hologrammen und vollfarbigen ("true colour") Hologrammen ist jedoch bereits eine geringe Wellenlängenverschiebung um > 20 nm ("Farbshift") problematisch, da der Gesamtfarbeindruck des Hologramms verfälscht wird.

Aufgabe der vorliegenden Erfindung war es daher, einen Schichtverbund der eingangs erwähnten Art bereit zu stellen, der mit einem Substrat verklebt werden kann, ohne dass es zu einer Wellenlängenverschiebung von mehr als 20 nm bei einem in den Photopolymerfilm einbelichteten Hologramm kommt.

Die Aufgabe ist durch einen Schichtaufbau gelöst, bei dem die Klebstoffschicht als Diffusionsbarriere für das Fluorurethan-Additiv C) ausgebildet ist.

Gemäß einer bevorzugten Ausführungsform der Erfindung ist vorgesehen, dass die Klebstoffschicht so ausgebildet ist, dass bei einer ATR-IR-Messung keine zeitabhängige Änderung des Absorptionsspektrums auftritt, wenn die die Klebstoffschicht mit dem Fluorurethan-Additiv benetzt wird. Zur Bestimmung werden in einem ersten Schritt jeweils das Infrarot-Spektrum des Fluorurethan-Additivs und der Klebstoffschicht mit Hilfe eines Infrarot-Spektrometers mit ATR-Messzelle (ATR: Abgeschwächte Totalreflexion) aufgenommen. Anschließend wird dann ein Stück der Klebstoffschicht gleichmäßig in definierter Schichtdicke auf die ATR-Messzelle aufgeklebt. Auf die freie Oberseite der Klebstoffschicht wird dann das Fluorurethan-Additiv aufgebracht. Die Menge des Additives muss dabei so bemessen sein, dass die über der ATR-Messzelle befindliche Fläche der Klebstoffschicht nach dem Verlaufen des Additives vollständig bedeckt ist. Zur Verfolgung der Diffusion des Additives in die Klebstoffschicht werden über einen ausreichenden Zeitraum in vorgegebenen zeitlichen Abständen IR-Spektren der Klebstoffschicht aufgenommen. Da die Eindringtiefe der totalreflektierten Strahlung im µm-Bereich liegt, kann das Fluorurethan-Additiv im IR-Spektrum erst dann detektiert werden, wenn es durch Diffusion die auf der ATR-Messzelle aufliegende Unterseite der Klebstoffschicht erreicht hat. Durch Subtraktion des IR-Spektrums der Klebstoffschicht zu Beginn der Messung von den zeitabhängigen Spektren während der Diffusion des Fluorurethan-Additivs, erhält man ein Differenzspektrum. Setzt man dieses Differenzspektrum in Relation zum IR-Spektrum des Fluorurethan-Additivs, kann die zeitabhängige Konzentration des Fluorurethan-Additiv an der Unterseite der Klebstoffschicht abgeschätzt werden.

Besonders bevorzugt ist, wenn während der Messdauer keine Peaks im Differenzspektrum von einer Extinktionsänderung von > 3,2 %, bevorzugt > 2,5 % und besonders bevorzugt > 1,5 % auftreten

Bei den erfindungsgemäßen Klebstoffschichten werden zu keinem Zeitpunkt Intensitätsunterschiede von mehr als 3 % in den Absorptionspeaks im Differenzspektrum festgestellt.

Gemäß einer weiteren bevorzugten Ausführungsform des erfindungsgemäßen Schichtverbunds ist vorgesehen, dass die Klebstoffschicht wenigstens eine Verbindung ausgewählt aus der Gruppe Synthesekautschuke, Chloroprenkautschuke, polyesterbasierte Schmelzklebstoffe, silicon-basierte Klebstoffe, urethan-basierte Klebstoffe hoher Netzwerkdichte, gegebenenfalls mit zusätzlichen strahlenhärtenden Gruppen oder basierend auf Urethanacrylaten, polyolefin-basierte Klebstoffe und Cyanacrylatklebstoffe umfasst oder daraus besteht. Besonders bevorzugt ist, wenn sie wenigstens eine Verbindung ausgewählt aus der Gruppe Synthesekautschuke, polyesterbasierte Schmelzklebstoffe, urethan-basierte Klebstoffe enthaltend Urethanacrylate und Cyanacrylatklebstoffe umfasst oder daraus besteht.

Unter Synthesekautschuken versteht man neben den Poly(isoprenen) auch Copolymerisate, die als weitere Monomere Acrylnitril und Derivate, Butadien, Styrol, Isobuten und andere umfassen oder daraus bestehen. Typische Copolymerisate sind Butadien-Nitril-Kautschuke (NBR), Styrol-Butadien-Kautschuke (SBR) und Isopren-Isobutylen-Kautschuke (IIR). Weitere Informationen in Müller/Rath, Formulierung von Kleb- und Dichtrohstoffen, 2009, ISBN: 978-3-86630-862-6, Kapitel 1.1.2.3 und 1.2.2. Besonders bevorzugt sind die unter Klebstoff 9, 10, 14 und 15 genannten Beispiele.

Chloropren-Kautschuke sind Polymere des 2-Chlor-1,3-butadien und gegebenenfalls eines mit Chloropren copolymerisierbaren ethylenisch ungesättigten Monomeren. Sie werden bevorzugt in Form von Dispersionen eingesetzt, die durch Emulsionspolymerisation im alkalischen Medium wie in WO02/24825 (S. 3, Z. 26- S. 7, Z. 4), DE-A 3 002 734 (S. 8, Z. 23- S. 12, Z. 9), WO2005035683(A1) (S. 16 ff.) oder US-A 5 773 544 (Sp. 2, Z. 9 bis Sp. 4, Z. 45) beschrieben erhalten werden können. Bevorzugt zu verwendende Dispersionen sind in BMS 11 1 206, S. 29f. beschrieben.

Unter polyesterbasierten Schmelzklebstoffen werden solche verstanden, die zu einem wesentlichen Gewichtsanteil von > 30 %, bevorzugt > 50% aus Polyestereinheiten bestehen. Exemplarisch sind Polyester im Teil b) dieser Anmeldung beschrieben, wobei für den Einsatz als Schmelzklebstoff jede beliebige Endgruppe wie Ester-, Ether-, Amid-, Säureendgruppe oder andere verwendbar ist. Bevorzugt werden Copolyestertypen eingesetzt, deren Zusammensetzung auch auf anderen Polymereinheiten wie Urethan-, Polyether-, Polyamid-oder Vinylacetatbindungen basiert. Insbesondere bevorzugt ist der Einsatz von dem als Klebstoff 6 beschriebenen Beispiel.

Unter siliconbasierten Klebstoffen werden solche verstanden, deren Verknüpfungseinheit Silikongruppen enthalten oder ausschließlich aus solchen bestehen. Silicone sind siliciumorganische Verbindungen, die im Rückgrat nur Si-O-Bindungen aufweisen. Häufig werden Silicone in Form von (Block- oder Graft-)Copolymeren mit Polyethern oder Polyestern oder anderen Polymereinheiten eingesetzt (modifizierte Silikone). Die Modifikationen erfolgen über die organischen Seitengruppen an den Siliciumatomen. Weitere Informationen in Müller/Rath, Formulierung von Kleb- und Dichtrohstoffen, 2009, ISBN: 978-3-86630-862-6, Kapitel 3.2.3. Insbesondere bevorzugt sind der Einsatz von Haftklebstoffen auf Silikonbasis wie z.B. im Beispiel 5 genannt.

Urethan-basierte Klebstoffe hoher Netzwerkdichte sind zweikomponentige Polyurethane, die dreidimensionale Netzwerke hoher Netzwerkdichten bilden, wie sie im Prinzip auch in den Matrixpolymeren A) eingesetzt werden. Dreidimensionale Netzwerkstrukturen hoher Netzwerkdichte sind insbesondere erhältlich, indem Komponenten umgesetzt werden, die zahlenmittlere Äquivalentmolmassen von < 1500 g/mol und besonders bevorzugt von < 1200 g/mol aufweisen. Ein bevorzugtes Beispiel ist Klebstoff 8.

Bevorzugt werden Mischungen aus Isocyanaten und isocyanat-funktionellen strahlenhärtenden Komponenten, insbesondere Urethanacrylate, eingesetzt. Geeignete Zusammensetzungen sind durch Umsetzung wenigstens einer strahlenhärtenden Komponente mit wenigstens einem Isocyanat-funktionellen Harz und wenigstens einem Photoinitiator erhältlich. Dabei ist es besonders bevorzugt, wenn in der strahlenhärtenden Komponente ≤ 5 Gew.-% Verbindungen mit einem gewichtsmittleren Molekulargewicht < 500 und ≥ 75 Gew.-% Verbindungen mit einem gewichtsmittleren Molekulargewicht > 1000 enthalten sind sowie in dem Isocyanat-funktionellen Harz ≤ 5 Gew.-% Verbindungen mit einem gewichtsmittleren Molekulargewicht < 500 enthalten sind.

Polyolefin-basierte Klebstoffe sind Polymere bevorzugt auf Basis der Monomere Propylen und Ethylen und werden häufig als Schmelzklebstoffe eingesetzt. Der Einsatz als Haftklebstoffe ist möglich. Ein Einsatz anderer rein C-H-basierter Comonomere ist denkbar, Zusatz von Vinylacetat wie er in Polyolefincopolymeren üblich ist, ist dagegen nicht geeignet.

Cyanacrylate sind die chemische Grundlage der im Markt bekannten "Sekundenklebstoffe". Es sind reaktive 1K-Systeme, die nach anionischem Mechanismus, in der Regel initiiert durch Luftfeuchtigkeit besonders schnell aushärten. Weitere Informationen zu verwendeten Rohstoffen und der Chemie der Härtung findet sich in Müller/Rath, Formulierung von Kleb-und Dichtrohstoffen, 2009, ISBN: 978-3-86630-862-6, Kapitel 2.3.2 beschrieben. Besonders geeignete Cyanacrylatklebstoffe sind die als Klebstoffe 17, 18, 20 genannten Beispielen.

Erfindungsgemäße Klebstoffe können bevorzugt in Form von Haftklebstoffen (als Haftklebebänder bzw. -folien), Schmelzklebstoffen (Hot Melts, Schmelzklebefolien) oder als flüssige Klebstoffformulierungen, die physikalisch, thermisch, chemisch oder strahlenhärtend trocknend sind, eingesetzt werden.

Haftklebstoffe (PSA = pressure sensitive adhesive) sind permanent klebrige Produkte, die im Kontakt mit Substraten bereits unter Anwendung eines leichten Anpressdruckes Adhäsion aufbauen. Der Verklebungsprozess erfolgt zeitlich unabhängig von der Applikation des Klebstoffes in der Regel auf einem Trägermaterial wie einem Release Liner, einem Abzugspapier oder einem (Folien-)Träger. Es kann verfahrensbedingt dennoch günstig sein, Haftklebstoffe bei erhöhten Temperaturen zu verarbeiten. Weitere Informationen in Müller/Rath, Formulierung von Kleb- und Dichtrohstoffen, 2009, ISBN: 978-3-86630-862-6, Kapitel 3.

Unter Schmelzklebstoffen versteht man amorphe oder teilkristalline Polymere, deren Glastemperatur oder kristalliner Punkt über der Raumtemperatur liegt. Bei Erwärmen über diesen Temperaturbereich hinaus erfolgt eine (teilweise langsame) Verflüssigung und es wird ein Viskositätsverhalten erreicht, das für eine Verklebung geeignet ist. Bei Abkühlen erfolgt dann Rekristallisation bzw. Verfestigung. Im Prinzip können auf diesem Weg auch hochmolekulare Polymere, deren Glastemperatur unterhalb der Raumtemperatur liegt als Schmelzklebstoffe fungieren. Solche Polymere sind beispielsweise durch Trocknung von Dispersionen oder physikalischen Lösungen zugänglich. Weitere Informationen in Müller/Rath, Formulierung von Kleb- und Dichtrohstoffen, 2009, ISBN: 978-3-86630-862-6, Kapitel 1.1.2.3 und 1.3.1.

Ebenfalls bevorzugt ist, wenn das Fluorurethan-Additiv C) wenigstens eine Verbindung der Formel (I) 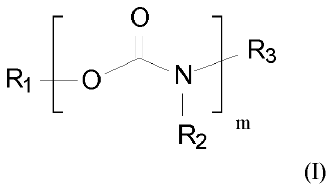 enthält oder daraus besteht, in der m≥1 und m≤8 ist und R1, R2, R3 unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste R1, R2, R3 mit wenigstens einem Fluoratom substituiert ist und besonders bevorzugt R1 ein organischer Rest mit mindestens einem Fluoratom ist.

Die Isocyanatkomponente a) umfasst bevorzugt Polyisocyanate. Als Polyisocyanate können alle dem Fachmann an sich bekannten Verbindungen oder deren Mischungen eingesetzt werden, die im Mittel zwei oder mehr NCO-Funktionen pro Molekül aufweisen. Diese können auf aromatischer, araliphatischer, aliphatischer oder cycloaliphatischer Basis sein. In untergeordneten Mengen können auch Monoisocyanate und/oder ungesättigte Gruppen enthaltende Polyisocyanate mitverwendet werden.

Beispielsweise geeignet sind Butylendüsocyanat, Hexamethylendiisocyanat (HDI), Isophorondiisocyanat (IPDI), 1,8-Diisocyanato-4-(isocyanatomethyl)-octan, 2,2,4- und/oder 2,4,4-Trimethylhexamethylendiisocyanat, die isomeren Bis-(4,4'-isocyanatocyclohexyl)methan und deren Mischungen beliebigen Isomerengehalts, Isocyanatomethyl-1,8-octandüsocyanat, 1,4-Cyclohexylendiisocyanat, die isomeren Cyclohexandimethylendiisocyanate, 1,4-Phenylendiisocyanat, 2,4- und/-oder 2,6-Toluylendiisocyanat, 1,5-Naphthylendiisocyanat, 2,4'- oder 4,4'-Di-phenylmethandiisocyanat und/oder Triphenylmethan-4,4',4''-triisocyanat.

Ebenfalls möglich ist der Einsatz von Derivaten monomerer Di- oder Triisocyanate mit Urethan-, Hamstoff-, Carbodiimid-, Acylhamstoff-, Isocyanurat-, Allophanat-, Biuret-, Oxadiazintrion-, Uretdion- und/oder Iminooxadiazindionstrukturen.

Bevorzugt ist der Einsatz von Polyisocyanaten auf Basis aliphatischer und/oder cycloaliphatischer Di- oder Triisocyanate.

Besonders bevorzugt handelt es sich bei den Polyisocyanaten der Komponente a) um di-oder oligomerisierte aliphatische und/oder cycloaliphatische Di- oder Triisocyanate.

Ganz besonders bevorzugt sind Isocyanurate, Uretdione und/oder Iminooxadiazindione basierend auf HDI sowie 1,8-Diisocyanato-4-(isocyanatomethyl)-octan oder deren Mischungen.

Ebenfalls können als Komponente a) NCO-funktionelle Prepolymere mit Urethan-, Allophanat-, Biuret- und/oder Amidgruppen eingesetzt werden. Prepolymere der Komponente a) werden in dem Fachmann an sich gut bekannter Art und Weise durch Umsetzung von monomeren, oligomeren oder Polyisocyanaten a1) mit isocyanatreaktiven Verbindungen a2) in geeigneter Stöchiometrie unter optionalem Einsatz von Katalysatoren und Lösemitteln erhalten.

Als Polyisocyanate a1) eignen sich alle dem Fachmann an sich bekannten aliphatischen, cycloaliphatischen, aromatischen oder araliphatischen Di- und Triisocyanate, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Hamstoff-, Carbodiimid-, Acylhamstoff-, Isocyanurat-, Allophanat-, Biuret-, Oxadiazintrion-, Uretdion-, Iminooxa-di-azindionstruktur jeweils einzeln oder in beliebigen Mischungen untereinander eingesetzt werden.

Beispiele für geeignete monomere Di- oder Triisocyanate, die als Komponente a1) eingesetzt werden können, sind Butylendüsocyanat, Hexamethylendiisocyanat (HDI), Isophorondiisocyanat (IPDI), Trimethyl-hexamethylen-diisocyanat (TMDI), 1,8-Diisocyanato-4-(isocyanatomethyl)-octan, Isocyanatomethyl-1,8-octandiisocyanat (TIN), 2,4- und/-oder 2,6-Toluen-diisocyanat.

Als isocyanatreaktive Verbindungen a2) zum Aufbau der Prepolymere werden bevorzugt OH- funktionelle Verbindungen eingesetzt. Diese sind analog den OH-funktionellen Verbindungen wie sie nachfolgend für die Komponente b) beschrieben sind.

Allophanate können auch im Gemisch mit anderen Prepolymeren oder Oligomeren der Komponente a1) eingesetzt werden. In diesen Fällen ist der Einsatz von OH-funktionellen Verbindungen mit Funktionalitäten von 1 bis 3,1 vorteilhaft. Beim Einsatz monofunktioneller Alkohole sind solche mit 3 bis 20 Kohlenstoffatomen bevorzugt.

Ebenfalls möglich ist der Einsatz von Aminen zur Prepolymerherstellung. Beispielsweise geeignet sind Ethylendiamin, Diethylentriamin, Triethylentetramin, Propylendiamin, Diaminocyclohexan, Diaminobenzol, Diaminobisphenyl, difunktionelle Polyamine wie z.B. die Jeffamine®, aminterminierte Polymere mit zahlenmittleren Molmassen bis 10000 g/Mol oder deren beliebige Gemische untereinander.

Zur Herstellung von biuretgruppenhaltigen Prepolymeren wird Isocyanat im Überschuss mit Amin umgesetzt, wobei eine Biuretgruppe entsteht. Als Amine eignen sich in diesem Falle für die Umsetzung mit den erwähnten Di-, Tri- und Polyisocyanaten alle oligomeren oder polymeren, primären oder sekundären, difunktionellen Amine der vorstehend genannten Art. Beispiele sind aliphatische Biurete auf Basis aliphatischer Amine und aliphatischer Isocyanate, insbesondere HDI und TMDI.

Bevorzugte Prepolymere sind Urethane, Allophanate oder Biurete aus aliphatischen Isocyanat-funktionellen Verbindungen und oligomeren oder polymeren Isocyanat-reaktiven Verbindungen mit zahlenmittleren Molmassen von 200 bis 10000 g/Mol.

Bevorzugt weisen die vorstehend beschriebenen Prepolymere Restgehalte an freiem monomeren Isocyanat von weniger als 2 Gew.-%, besonders bevorzugt weniger als 1,0 Gew.-%, ganz besonders bevorzugt weniger als 0,5 Gew.-% auf.

Selbstverständlich kann die Isocyanatkomponente anteilsmäßig neben den beschriebenen Prepolymeren weitere Isocyanatkomponenten enthalten. Es ist gegebenenfalls auch möglich, dass die Isocyanatkomponente a) anteilsmäßig Isocyanate enthält, die teilweise mit isocyanat-reaktiven ethylenisch ungesättigten Verbindungen umgesetzt sind.

Es ist gegebenenfalls auch möglich, dass die vorgenannten Isocyanatkomponente a) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Als Komponente b) können an sich alle polyfunktionellen, isocyanatreaktiven Verbindungen eingesetzt werden, die im Mittel wenigstens 1.5 isocyanatreaktive-Gruppen pro Molekül aufweisen.

Isocyanatreaktive Gruppen im Rahmen der vorliegenden Erfindung sind bevorzugt Hydroxy-, Amino- oder Thiogruppen, besonders bevorzugt sind Hydroxyverbindungen.

Geeignete polyfunktionelle, isocyanatreaktive Verbindungen sind beispielsweise Polyester-, Polyether-, Polycarbonat-, Poly(meth)acrylat- und/oder Polyurethanpolyole.

Daneben sind als Bestandteile der Komponente b) als polyfunktionelle, isocyanatreaktive Verbindungen auch niedermolekulare, d.h. mit Molekulargewichten kleiner 500 g/mol, kurzkettige, d.h. 2 bis 20 Kohlenstoffatome enthaltende aliphatische, araliphatische oder cycloaliphatische di, tri oder polyfunktionelle Alkohole geeignet.

Dies können beispielsweise sein Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexan-diol, 1,2- und 1,4-Cyclohexandiol, hydriertes Bisphenol A (2,2-Bis(4-hydroxycyclohexyl)propan), 2,2-Dimethyl-3-hydroxypropionsäure (2,2-dimethyl-3-hydroxypropylester). Beispiele geeigneter Triole sind Trimethylolethan, Trimethylolpropan oder Glycerin. Geeignete höherfunktionelle Alkohole sind Ditrimethylolpropan, Pentaerythrit, Dipentaerythrit oder Sorbit.

Als Polyesterpolyole sind beispielsweise lineare Polyesterdiole oder verzweigte Polyesterpolyole geeignet, wie sie in bekannter Weise aus aliphatischen, cycloaliphatischen oder aromatischen Di- bzw. Polycarbonsäuren bzw. ihren Anhydriden mit mehrwertigen Alkoholen einer OH-Funktionalität ≥ 2 erhalten werden. Bevorzugte Polyesterpolyole basieren auf aliphatischen Alkoholen und Mischungen aus aliphatischen und aromatischen Säuren und haben zahlenmittlere Molmassen zwischen 500 und 10000 g/Mol und Funktionalitäten zwischen 1,8 und 6,1.

Die Polyesterpolyole können auch auf natürlichen Rohstoffen wie Rizinusöl basieren. Ebenfalls möglich ist, dass die Polyesterpolyole auf Homo- oder Mischpolymerisaten von Lactonen basieren, wie sie bevorzugt durch Anlagerung von Lactonen bzw. Lactongemischen im Rahmen einer ringöffnenden Lacton-Polymerisation wie Butyrolacton, ε-Caprolacton und/oder Methyl-ε-caprolacton an hydroxyfunktionelle Verbindungen wie mehrwertige Alkohole einer OH-Funktionalität ≥ 2 oder Polyole eine Funktionalität von größer 1,8 beispielsweise der vorstehend genannten Art erhalten werden können.

Beispiele für hier als Starter eingesetzte Polyole sind Polyetherpolyole einer Funktionalität von 1,8 bis 3,1 mit zahlenmittleren Molmassen von 200 bis 4000 g/mol, bevorzugt sind Poly(tetrahydrofurane) mit einer Funktionalität von 1,9 bis 2,2 und zahlenmittleren Molmassen von 500 bis 2000 g/mol. Als Anlagerungsprodukte sind Butyrolacton, ε-Caprolacton und/oder Methyl-ε-caprolacton, ε-Caprolacton ist besonders bevorzugt.

Geeignete Polycarbonatpolyole sind in an sich bekannter Weise durch Umsetzung von organischen Carbonaten oder Phosgen mit Diolen oder Diol-Mischungen zugänglich.

Geeignete organische Carbonate sind Dimethyl-, Diethyl- und Diphenylcarbonat.

Geeignete Diole bzw. Mischungen umfassen die an sich im Rahmen der Polyestersegmente genannten mehrwertigen Alkoholen einer OH-Funktionalität ≥ 2, bevorzugt 1,4-Butandiol, 1,6-Hexandiol und/oder 3-Methylpentandiol, oder auch Polyesterpolyole können zu Polycarbonatpolyolen umgearbeitet werden.

Geeignete Polyetherpolyole sind gegebenenfalls blockweise aufgebaute Polyadditionsprodukte cyclischer Ether an OH- oder NH-funktionelle Startermoleküle.

Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können die an sich im Rahmen der Polyesterpolyole genannten mehrwertigen Alkohole einer OH-Funktionalität ≥ 2 sowie primäre oder sekundäre Amine und Aminoalkohole verwendet werden.

Bevorzugte Polyetherpolyole sind solche der vorgenannten Art ausschließlich basierend auf Propylenoxid oder statistische oder Block-Copolymere basierend auf Propylenoxid mit weiteren 1-Alkylenoxiden, wobei der 1-Alykenoxidanteil nicht höher als 80 Gew.-% ist. Besonders bevorzugt sind Propylenoxid-homopolymere sowie statistische oder Block-Copolymere, die Oxyethylen-, Oxypropylen- und/oder Oxybutyleneinheiten aufweisen, wobei der Anteil der Oxypropyleneinheiten bezogen auf die Gesamtmenge aller Oxyethylen-, Oxypropylen-und Oxybutyleneinheiten mindestens 20 Gew.-%, bevorzugt mindestens 45 Gew.-% ausmacht. Oxypropylen- und Oxybutylen- umfasst hierbei alle jeweiligen linearen und verzweigten C3- und C4-Isomere.

Als spezielle Polyetherpolyole werden bevorzugt solche eingesetzt, die aus einer isocyanat-reaktiven Komponente umfassend hydroxyfunktionelle Multiblockcopolymere des Typs Y(Xi-H)n mit i = 1 bis 10 und n = 2 bis 8 und zahlenmittleren Molekulargewichten von größer 1500 g/Mol bestehen, wobei die Segmente Xi jeweils aus Oxyalkyleneinheiten der Formel (X) aufgebaut sind,

-CH2-CH(R)-O- Formel (X)

wobei R ein Wasserstoff-, Alkyl-, oder Arylrest, ist, der auch substituiert oder durch Heteroatome (wie Ethersauerstoffe) unterbrochen sein kann, Y der zugrundeliegende Starter ist und der Anteil der Segmente Xi bezogen auf die Gesamtmenge der Segmente Xi und Y wenigstens 50 Gew.-% ausmacht.

In Formel (X) ist R bevorzugt ein Wasserstoff, eine Methyl-, Butyl-, Hexyl- oder Octylgruppe oder ein ethergruppenhaltiger Alkylrest. Bevorzugte ethergruppenhaltiger Alkylreste sind solche basierend auf Oxyalkyleneinheiten.

Die Multiblockcopolymere Y(Xi-H)n haben bevorzugt zahlenmittlere Molekulargewichte von mehr als 1200 g/Mol, besonders bevorzugt mehr als 1950 g/Mol, jedoch bevorzugt nicht mehr als 12000 g/Mol, besonders bevorzugt nicht mehr als 8000 g/Mol.

Bevorzugt eingesetzte Blockcopolymere der Struktur Y(Xi-H)n bestehen zu mehr als 50 Gewichtsprozent aus den oben beschriebenen Blöcken Xi und haben eine zahlenmittlere Gesamtmolmasse von größer 1200 g/Mol.

Bevorzugte Kombinationen aus Komponente a) und b) bei der Herstellung der Matrixpolymere sind:
I) Additionsprodukte von Butyrolacton, ε-Caprolacton und/oder Methyl-ε-caprolacton an Polyetherpolyolen einer Funktionalität von 1,8 bis 3,1 mit zahlenmittleren Molmassen von 200 bis 4000 g/mol in Verbindung mit Isocyanuraten, Uretdionen, Iminooxadiazindionen und/oder anderen Oligomeren basierend auf HDI. Besonders bevorzugt Additionsprodukte von ε-Caprolacton an Poly(tetrahydrofurane) mit einer Funktionalität von 1,9 bis 2,2 und zahlenmittleren Molmassen von 500 bis 2000 g/mol (insbesondere 600 bis 1400 g/mol), deren zahlenmittlere Gesamtmolmasse von 800 bis 4500 g/Mol, insbesondere von 1000 bis 3000 g/Mol liegt in Verbindung mit Oligomeren, Isocyanuraten und/oder Iminooxadiazindionen basierend auf HDI.
II) Polyetherpolyole mit zahlenmittlere Molmassen von 500 bis 8500 g/Mol und OH-Funktionalitäten von 1,8 bis 3,2, ausschließlich basierend auf Propylenoxid oder statistische oder Block-Copolyole basierend auf Propylenoxid und Ethylenoxid, wobei der Ethylenoxidanteil nicht höher als 60 Gew.-% ist in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol. Besonders bevorzugt sind Propylenoxid-homopolymere mit zahlenmittlere Molmassen von 1800 bis 4500 g/Mol und OH-Funktionalitäten von 1,9 bis 2,2 in Verbindung mit Allophanaten aus HDI oder TMDI und difunktionellen Polyetherpolyolen (insbesondere Polypropylenglykolen) mit zahlenmittleren Molmassen von 200 bis 2100 g/Mol.
III) Polyetherblock- oder -multiblockcopolymere der Formel (I), wobei Y ein rein aliphatisches Polycarbonatpolyol oder ein Polymer des Tetrahydrofurans mit jeweils einer OH-Funktionalität von 1,8 bis 3,1 und einer zahlenmittlere Molmassen von 400 bis 2000 g/Mol ist, n = 2, i = 1 oder 2 und R = Methyl oder H ist, mit einer gesamten zahlenmittleren Molmasse von 1950 bis 9000 g/mol in Verbindung mit Urethanen, Allophanaten oder Biureten aus aliphatischen Isocyanat-funktionellen Verbindungen und oligomeren oder polymeren Isocyanat-reaktiven Verbindungen mit zahlenmittleren Molmassen von 200 bis 6000 g/Mol oder in Verbindung mit Isocyanuraten, Uretdionen, Iminooxadiazindionen und/oder anderen Oligomeren basierend auf HDI. Besonders bevorzugt sind Polyetherblock- oder -multiblockcopolymere der Formel (I), wobei Y ein rein aliphatisches Polycarbonatpolyol auf Basis 1,4-Butandiol und/oder 1,6-Hexandiol mit Dimethyl- oder Diethylcarbonat oder ein Polymer des Tetrahydrofurans mit einer OH-Funktionalität von 1,8 bis 2,2 und einer zahlenmittlere Molmassen von 600 bis 1400 g/Mol (insbesondere bis 1000 g/Mol) ist, n = 2, i = 1 oder 2 und R = Methyl oder H ist, wobei der Anteil der Ethylenoxideinheiten an der Gesamtmasse von Xi nicht höher als 60 Gew.-% ist, in Verbindung mit Allophanaten aus HDI oder TMDI und difunktionellen Polyetherpolyolen (insbesondere Polypropylenglykolen) mit zahlenmittleren Molmassen von 200 bis 2100 g/Mol, in Verbindung mit Biureten mit zahlenmittleren Molmassen von 200 bis 1400 g/Mol (insbesondere auch im Gemisch mit anderen Oligomeren difunktioneller aliphatischer Isocyanate) basierend auf aliphatischer Diaminen oder Polyaminen und aliphatischen Diisocyanaten, insbesondere HDI und TMDI, in Verbindung mit Urethanen aus HDI oder TMDI auf Basis von Additionsprodukten von Butyrolacton, ε-Caprolacton und/oder Methyl-ε-caprolacton (insbesondere ε-Caprolacton) an 2 bis 20 Kohlenstoffatome enthaltende aliphatische, araliphatische oder cycloaliphatische di-, tri- oder polyfunktionelle Alkohole (insbesondere an difunktionelle aliphatische Alkohole mit 3 bis 12 Kohlenstoffatomen) mit zahlenmittleren Molmassen von 200 bis 3000 g/Mol, insbesondere bevorzugt von 1000 bis 2000 g/Mol (insbesondere im Gemisch mit anderen Oligomeren difunktioneller aliphatischer Isocyanate) oder in Verbindung mit Isocyanuraten, Iminooxadiazindionen und/oder anderen Oligomeren basierend auf HDI.

Die vernetzten Schreibmonomere B) werden bevorzugt durch Umsetzung von einer oder mehrerer verschiedene Verbindungen mit strahlungshärtenden Gruppen unter Einwirkung aktinischer Strahlung erhalten.

Verbindungen mit strahlungshärtenden Gruppen können Verbindungen wie α,β-ungesättigte Carbonsäurederivate wie Acrylate, Methacrylate, Maleinate, Fumarate, Maleimide, Acrylamide, weiterhin Vinylether, Propenylether, Allylether und Dicyclopentadienyl-Einheiten enthaltende Verbindungen sowie olefinisch ungesättigte Verbindungen wie z.B. Styrol, α-Methylstyrol, Vinyltoluol, Olefine, wie z.B. 1-Octen und/oder 1-Decen, Vinylestern, (Meth)acrylnitril, (Meth)acrylamid, Methacrylsäure, Acrylsäure sein.

Bevorzugt sind sind Acrylate und / oder Methacrylate.

Ganz besonders bevorzugt ist, wenn die Schreibmonomere B) photochemisch vernetzte Acrylate sind.

Als Acrylate bzw. Methacrylate werden allgemein Ester der Acrylsäure bzw. Methacrylsäure bezeichnet. Beispiele verwendbarer Acrylate und Methacrylate sind Methylacrylat, Methylmethacrylat, Ethylacrylat, Ethylmethacrylat, Ethoxyethylacrylat, Ethoxyethylmethacrylat, n-Butylacrylat, n-Butylmethacrylat, tert.-Butylacrylat, tert.-Butylmethacrylat, Hexylacrylat, Hexylmethacrylat, 2-Ethylhexylacrylat, 2-Ethylhexylmethacrylat, Butoxyethylacrylat, Butoxyethylmethacrylat, Laurylacrylat, Laurylmethacrylat, Isobornylacrylat, Isobomylmethacrylat, Phenylacrylat, Phenylmethacrylat, p-Chlorphenylacrylat, p-Chlorphenylmethacrylat, p-Bromphenylacrylat, p-Bromphenyl-methacrylat, 2,4,6-Trichlorphenylacrylat, 2,4,6-Trichlorphenylmethacrylat, 2,4,6-Tribromphenyl-acrylat, 2,4,6-Tribromphenylmethacrylat, Pentachlorphenylacrylat, Pentachlorphenylmethacrylat, Pentabromphenylacrylat, Pentabromphenylmethacrylat, Pentabrombenzylacrylat, Pentabrombenzylmethacrylat, Phenoxyethylacrylat, Phenoxyethylmethacrylat, Phenoxyethoxyethylacrylat, Phenoxyethoxyethylmethacrylat, 2-Naphthylacrylat, 2-Naphthylmethacrylat, 1,4-Bis-(2-thionaphthyl)-2-butylacrylat, 1,4-Bis-(2-thionaphthyl)-2-butylmethacrylat, Propan-2,2-diylbis[(2,6-dibrom-4,1-phenylen)oxy(2-{[3,3,3-tris(4-chlorphenyl)-propanoyl]-oxy}propan-3,1-diyl)oxyethan-2,1-diyl]-diacrylat, Bisphenol A Diacrylat, Bisphenol A Dimethacrylat, Tetrabromobisphenol A Diacrylat, Tetrabromobisphenol A Dimethacrylat sowie deren ethoxylierte Analogverbindungen, N-Carbazolylacrylate um nur eine Auswahl verwendbarer Acrylate und Methacrylate zu nennen.

Bevorzugt werden Acrylate und Methacrylate mit einem Brechungsindex nD20 (gemessen bei einer Wellenlänge von 405 nm) von größer 1,450 eingesetzt. Besonders bevorzugt werden Acrylate eingesetzt, die mindestens eine aromatische Struktureinheit enthalten und einen Brechungsindex nD20 (405 nm) von größer 1,500 haben. Als besonders geeignete Beispiele hierfür sind Acrylate und Methacrylate auf Basis von Bisphenol A oder dessen Derivate zu nennen sowie solche Acrylate und Methacrylate, die eine Thioarylgruppe enthalten.

Selbstverständlich können auch Urethanacrylate als Verbindungen mit strahlungshärtenden Gruppen verwendet werden. Unter Urethanacrylaten versteht man Verbindungen mit mindestens einer Acrylsäureestergruppe die zusätzlich über mindestens eine Urethanbindung verfügen. Es ist bekannt, dass solche Verbindungen durch Umsetzung eines Hydroxyfunktionellen Acrylsäureesters mit einer Isocyanat-funktionellen Verbindung erhalten werden können.

Beispiele für Urethanacrylate und/ oder Urethanmethacrylate sind die Additionsprodukte aromatischer Triisocyanate (ganz besonders bevorzugt Tris-(4-phenylisocyanato)-thiophosphat oder Trimere aromatischer Diisocyanate wie Toluylendiisocyanat) mit Hydroxyethylacrylat, Hydroxypropylacrylat, 4-Hydroxybutylacrylat, die Additionsprodukte von 3-Thiomethyl-phenylisocyanat mit Hydroxyethylacrylat, Hydroxypropylacrylat, 4-Hydroxybutylacrylat sowie ungesättigte Glycidyletheracrylaturethane (wie in den Anmeldungen WO 2008/125229 A1 und in der EP 2 154 129 beschrieben) oder deren beliebige Mischungen untereinander.

In Weiterbildung der Erfindung ist vorgesehen, dass der Photopolymerfilm zusätzlich einen Photoinitiator D) und / oder einen Katalysator E) umfasst.

Als Komponente D) können ein oder mehrere Photoinitiatoren eingesetzt. Das verwendete Photoinitiatorsystem kann vorzugsweise einen anionischen, kationischen oder neutralen Farbstoff und einen Coinitiator umfassen. Beispiele sind Mischungen aus Tetrabutylammonium Triphenylhexylborat, Tetrabutylammonium Triphenylbutylborat, Tetrabutylammonium Trinapthylbutylborat, Tetrabutylammonium Tris-(4-tert.-butyl)-phenylbutylborat, Tetrabutylammonium Tris-(3-fluorphenyl)-hexylborat und Tetrabutylammonium Tris-(3-Chlor-4-methylphenyl)-hexylborat mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin.

Es können ein oder mehrere Katalysatoren E) eingesetzt werden. Dabei handelt es sich um Katalysatoren zur Beschleunigung der Urethanbildung. Bekannte Katalysatoren hierfür sind beispielsweise Zinnoctoat, Zinkoktoat, Dibutylzinndilaurat, Dimethylbis[(1-oxoneodecyl)oxy]stannan, Dimethylzinndicarboxylat, Zirkonium-bis(ethylhexanoat), Zirconium-acteylacetonat oder tertiäre Aminen wie beispielsweise 1,4-Diazablcyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin, Monobutyl-zinn-tris(2-ethylhexanoat).

Bevorzugt sind Dibutylzinndilaurat, Dimethylbis[(1-oxoneodecyl)oxy]stannan, Dimethylzinndicarboxylat, 1,4-Diazablcyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin und Monobutyl-zinn-tris(2-ethylhexanoat).

Weitere Bestandteile des Photopolymerfilms können Radikalstabilisatoren oder andere Hilfs-und Zusatzstoffe wie Weichmacher sein.

Als Beispiele für Radikalstabilisatoren sind Inhibitoren und Antioxidantien wie sie z.B. in "Methoden der organischen Chemie" (Houben-Weyl), 4. Auflage, Band XIV/1, S. 433ff, Georg Thieme Verlag, Stuttgart 1961, beschrieben sind, geeignet. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-tert.-Butylchinon, ggf. auch aromatische Amine wie Diisopropylamin oder Phenothiazin.

Bevorzugt sind 2,6-Di-tert.-butyl-4-methylphenol, Phenothiazin, p-Methyoxyphenol, 2-Methoxy-p-hydrochinon und Benzhydrol.

In den Photopolymerfilm kann insbesondere ein Hologramm einbelichtet sein. Durch entsprechende Belichtungsprozesse können Hologramme für optische Anwendungen im gesamten sichtbaren Bereich sowie im nahen UV-Bereich (300 - 800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyukhologramme, Off-Axis Reflektionshologramme, Edge-Lit Hologramme sowie Holographische Stereogramme, bevorzugt sind Reflexionshologramme, Denisyukhologramme, Transmissionshologramme. Bevorzugt sind optische Elemente wie Linsen, Spiegel, Umlenkspiegel, Filter, Streuscheiben, Beugungselemente, Lichtleiter, Lichtlenker (waveguides), Projektionsscheiben und/oder Masken haben. Häufig zeigen diese optischen Elemente eine Frequenzselektivität je nachdem wie die Hologramme belichtet wurden und welche Dimensionen das Holgramm hat.

Gemäß einer weiteren bevorzugten Ausführungsform ist vorgesehen, dass die Klebstoffschicht eine Dicke im Bereich von 3 bis 100 µm, bevorzugt von 10 bis 75 µm und besonders bevorzugt von 15 bis 55 µm aufweist.

Ebenfalls bevorzugt ist, wenn Klebstoffschicht vollflächig mit dem Photopolymerfilm verbunden ist.

Der erfindungsgemäße Schichtverbund kann auch noch weitere Schichten umfassen. So kann beispielsweise die Klebstoffschicht lösbar mit einer Abdeckschicht versehen sein. Ebenso ist es möglich, dass der Schichtverbund eine zweite Klebstoffschicht aufweist. Beide Klebstoffschichten können in diesem Fall insbesondere mit den gegenüberliegenden Seiten des Photopolymerfilms verbunden sein.

Die Klebstoffschicht kann insbesondere mit Laminiergeräten oder über ein Rolle-zu-Rolle-Verfahren auf den Photopolymerfilm aufgebracht werden.

Die Klebstoffschicht kann über ein Transferverfahren oder als flüssiger Klebstoff aufgebracht werden.

Im Fall einer flüssigen Auftragung kann die Formulierung aus einer oder mehreren Komponenten bestehen, die vor der Auftragung durch geeignete Techniken gemischt werden können. Zur Applikation auf den Photopolymerfilm sind alle jeweiligen gängigen, dem Fachmann bekannten Verfahren geeignet, wie insbesondere Rakeln, Gießen, Drucken, Siebdruck, Sprühapplikation, Tröpfchen- oder Streifenantrag über Düsen, Spritzen, oder Inkjet-Druck. Bevorzugt sind Tröpfchen- oder Streifenantrag über Düsen, Rakel, Sprühapplikation, Druckverfahren und insbesondere Siebdruck sowie Schlitzdüsen geeignet. Je nach Klebstoff sind geeignete Trocknungsparameter möglich (physikalische, thermische Trocknung, Ablüften, UV-Licht für Strahlenhärtung, Härtung durch Luftsauerstoff). Die Trocknung oder Härtung kann vollständig im Kontakt mit dem Photopolymerfilm und dem Klebstoffsubstrat erfolgen als auch als (Teil-)Härtung solange nur Kontakt zu einer der beiden Unterlagen (Photopolymerschicht oder Klebstoffsubstrat) besteht mit anschließendem Kontaktschluss.

Das Klebstoffschichttransferverfahren eignet sich insbesondere, wenn keine flüssigen Chemikalien gehandhabt werden sollen oder wenn die Schichtdicke der Klebstoffschicht präzise eingestellt werden soll. Dabei wird in einem vorgelagerten Schritt die Klebstoffschicht auf ein wiederablösbares Substrat appliziert und ggf. mit einer weiteren ablösbaren Kaschierfolie geschützt. Im Klebstoffschichttransferverfahren wird dann die Kaschierfolie abgezogen und der Klebstoff direkt auf den Photopolymerfilm auflaminiert. Es ist möglich, dass das Substrat des Klebstoffes im Produkt verbleibt, im anderen Fall dient sie als Transfersubstrat bis zur Applikation des Schichtaufbaus in die endgültige Anwendung.

Selbstverständlich kann die Klebstoffschicht sowohl durch flüssige Auftragung als auch durch Klebstoffschichttransferverfahren auch auf das zu verklebende Substrat appliziert werden. Geeignete Substrate sind Papier, Thermoplasten, Duroplasten, Metallen, Glas, Holz, lackierten, beschichteten, laminierten oder bedruckten Substraten etc. Es kann dabei von Vorteil sein, die Substrate vorzubehandeln. Bespiele hierfür sind chemische Vorbehandlung mit Lösemitteln, zur Vorreinigung wie Entfettung, physikalische Vorbehandlung wie Plasmabehandlung oder Koronabehandlung, Strahlungsaktivierung, Abscheidung oder Auftragung haftvermittelnder Schichten.

Gemäß einer weiteren bevorzugten Ausführungsform der Erfindung kann in die Photopolymerfilm ein Hologramm einbelichtet sein. Die Hologramme können beliebige holografische Volumenhologramme sein, die nach dem Fachmann bekannten Verfahren aufgezeichnet wurden. Darunter fallen unter anderem monochromatisch belichtete oder mit mehreren Lasern unterschiedlicher Emissionswellenlänge erzeugte mehr- oder vollfarbige Reflektionshologramme, In-Line (Gabor) Hologramme, Off-Axis Hologramme, Full-Aperture Transfer Hologramme, Weißlicht-Transmissionshologramme ("Regenbogenhologramme"), Lippmannhologramme, Denisyukhologramme, Off-Axis Reflektionshologramme, Edge-Lit Hologramme sowie holographische Stereogramme.

Mögliche optische Funktionen der Hologramme, entsprechen den optische Funktionen von Lichtelementen wie Linsen, Spiegel, Umlenkspiegel, Filter, Streuscheiben (mit und ohne eingeschränkte Sichtzone (eye box), Beugungselemente, Lichtleiter, Lichtlenker (waveguides), Projektionsscheiben, Masken, optische Prismen zur spektralen chromatischen Aufspaltung, Lichtlenkung und Lichtführung sowie Lichtformung. Häufig zeigen diese optischen Elemente eine Frequenzselektivität, je nachdem wie die Hologramme belichtet wurden und welche Dimensionen das Hologramm hat.Zudem können mittels der erfindungsgemäßen Schichtaufbauten auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

Generell kann der erfindungsgemäße Schichtverbund in jedes Produkt mit einer holografischen Anwendung integriert werden. Bevorzugt wird er in Chipkarten oder Ausweisdokumente eingeklebt werden. Ebenso ist eine Verwendung als Produktschutzetikett, als Label, in Banknoten in Form eines Streifens oder Fensters bevorzugt. Auch ist es bevorzugt holografisch optische Elemente entsprechend dem beschriebenen Schichtaufbau in Aufbauten wie Displays zu intergrieren. Weiterhin können 3D Hologramme mit dem erfindungsgemäßen Schichtverbund mit (schwarzen) Hintergrundfolien verklebt werden ohne dass es zu Farbverschiebungen in den Hologrammen kommt.

Ein weiterer Gegenstand der Erfindung ist die Verwendung eines erfindungsgemäßen Schichtverbunds zur Herstellung von Chipkarten, Ausweisdokumenten oder 3D-Bildern, als Produktschutzetikett, als Label, in Banknoten in Form eines Streifens oder Fensters oder als holografisch optische Elemente in Displays.

### Beispiele:

Die Erfindung wird im Folgenden anhand von Beispielen näher erläutert.

### Methoden:

### Festkörpergehalt oder Festgehalt:

Von einem unlackierten Dosendeckel und einer Büroklammer wurde das Tara-Gewicht ermittelt. Dann wurden ca. 1g der zu untersuchenden Probe nach der Einwaage in dem Dosendeckel mit der geeignet gebogenen Büroklammer gleichmäßig verteilt. Die Büroklammer verblieb zur Messung in der Probe. Die Einwaage wurde ermittelt, danach für 1 Stunde bei 125 °C in einen Laborofen erhitzt und anschließend die Auswaage bestimmt. Den Festkörpergehalt wurde gemäß folgender Gleichung bestimmt: Auswaage [g] * 100 / Einwaage [g] = Gew.-% Festkörper.

### Isocyanat-Gehalte

Die angegebenen NCO-Werte (Isocyanat-Gehalte) wurden gemäß DIN EN ISO 11909 bestimmt.

### Messung der Trockenschichtdicke der Photopolymere

Die physikalische Schichtdicke wurde mit marktgängigen Weisslichtinterferometern ermittelt, wie z.B. das Gerät FTM-Lite NIR Schichtdickenmessgerät der Firma Ingenieursbüro Fuchs.

Die Bestimmung der Schichtdicke beruht im Prinzip auf Interferenzerscheinungen an dünnen Schichten. Dabei überlagern sich Lichtwellen, die an zwei Grenzflächen unterschiedlicher optischer Dichte reflektiert worden sind. Die ungestörte Überlagerung der reflektierten Teilstrahlen führt nun zur periodischen Aufhellung und Auslöschung im Spektrum eines weißen Kontinuumstrahlers (z.B. Halogenlampe). Diese Überlagerung nennt der Fachmann Interferenz. Diese Interferenzspektren werden gemessen und mathematisch ausgewertet.

### ATR-IR-Messung zur Ermittlung der Differenzspektren

Für die Messungen wurden Prüfkörper der flüssigen Klebstoffe hergestellt. Dazu wurden auf einer Glasplatte Filme der Trockenschichtdicke 20 µm mit einem Spiralrakel oder Kastenrakel aufgetragen und der Klebstoff wie unter dem Punkt "Aufbringen der Klebstoffschichten" beschrieben ausgehärtet. Die eingesetzten Transferklebebänder wurden wie vom Hersteller erhalten auf die Messzelle aufgebracht.

Es wurde ein FT-IR-Spektrometer Typ ALPHA der Fa. BrukerOptik GmbH, Ettlingen, Deutschland mit einer ATR (abgeschwächte Totalreflexion)-Messzelle aus ZnSe verwendet. Die Spektren wurden im Wellenzahlbereich von 550 bis 4000 cm⁻¹ mit einer Auflösung von 4 cm⁻¹ aufgenommen.

Von der Klebstoffschicht wurde wie oben beschrieben ein ATR-IR Spektrum aufgenommen, dann wurde auf die freie Oberseite der Klebstoffschicht das Fluorurethan-Additiv 1 per Tropfen so aufgebracht, dass die über der ATR-Meßzelle befindliche Fläche vollständig benetzt war. Zur Verfolgung der Diffusion des Additives 1 in die Klebstoffschicht wurden über einen ausreichenden Zeitraum in vorgegebenen zeitlichen Abständen von 1, 3 und 5 Tagen IR-Spektren der Klebstoffschicht aufgenommen.

Die ausgewiesenen Differenzspektren wurden erhalten, indem man das zu Beginn der Messung aufgenommene Spektrum des Klebstofffilms von den nach 1 , 3 und 5 Tagen erhaltenen Spektren des Klebstofffilms subtrahiert. Teilweise wurden die Messungen aus experimentellen Gründen bereits nach 3 Tagen abgeschlossen.

Um sicherzustellen , dass die Differenzpeaks tatsächlich von einer Diffusion des Additives 1 herrührten und um die Konzentration des Additives an der Unterseite der Klebstoffschicht abzuschätzen, wurden die Differenzspektren mit dem Infrarot-Spektrum des Fluorurethan-Additivs 1 verglichen.

### Verwendete Einsatzstoffe zur Herstellung der Photopolymerfilme:

Polyurethan-Matrixpolymere A): aus Desmodur® N 3900 (Polyisocyanat a), Produkt der Bayer MaterialScience AG, Leverkusen, Deutschland, Hexandiisocyanat-basiertes Polyisocyanat, Anteil an Iminooxadiazindion mindestens 30 %, NCO-Gehalt: 23,5 %, und Polyol 1 (Polyol b)).

Polyol 1: experimentelles Produkt der Bayer MaterialScience AG, Leverkusen, Deutschland, die Herstellung ist unten beschrieben.

Schreibmonomer 1: experimentelles Produkt der Bayer MaterialScience AG, Leverkusen, Deutschland, die Herstellung ist unten beschrieben.

Schreibmonomer 2: experimentelles Produkt der Bayer MaterialScience AG, Leverkusen, Deutschland, die Herstellung ist unten beschrieben.

Additiv 1: experimentelles Produkt der Bayer MaterialScience AG, Leverkusen, Deutschland, die Herstellung ist unten beschrieben.

Photointitiator 1: Neumethylenblau 0,20 %, Safranin O 0,10 % und Astrazon Orange G 0,10% mit CGI 909 (Produkt der BASF SE, Basel, Schweiz) 1,5%, als Lösung in N-Ethylpyrrolidon (NEP) gelöst, Anteil NEP 3,5%.

Katalysator 1: Fomrez^{®} UL28 0,5%, Urethanisierungskatalysator, Dimethylbis[(1-oxoneodecl)oxy]stannan, Handelsprodukt der Momentive Performance Chemicals, Wilton, CT, USA (als 10%ige Lösung in N-Ethylpyrrolidon eingesetzt).

Katalysator 2: Fascat 4102, Monobutyl-zinn-tris(2-ethylhexanoat), Produkt der Arkema GmbH, Düsseldorf, Deutschland.

Byk® 310 (silikonbasiertes Oberflächenadditiv der BYK-Chemie GmbH, Wesel, Deutschland, 25%ige Lösung in Xylol) 0,3%.

Substrat 1: Makrofol DE 1-1 CC 175 µm (Bayer MaterialScience AG, Leverkusen, Deutschland).

Substrat 2: Polyethylenterephthalat-Folie, 36 µm, Typ Hostaphan® RNK, von Mitsubishi Chemicals, Deutschland.

Substrat 3: Makrofol DE 1-1 CC 125 µm (Bayer MaterialScience AG, Leverkusen, Deutschland).

### Herstellung der Komponenten:

### Polyol 1:

In einem 1 L Kolben wurden 0,18 g Zinnoktoat, 374.8 g ε-Caprolacton und 374.8 g eines difunktionellen Polytetrahydrofuranpolyetherpolyols (Equivalentgewicht 500 g/Mol OH) vorgelegt und auf 120 °C aufgeheizt und so lange auf dieser Temperatur gehalten, bis der Festgehalt (Anteil der nicht-flüchtigen Bestandteile) bei 99.5 Gew.-% oder darüber lag. Anschließend wurde abgekühlt und das Produkt als wachsiger Feststoff erhalten.

### Schreibmonomer 1 (Phosphorthioyltris(oxy-4,1-phenyleniminocarbonyloxyethan-2,1-diyl)-triacrylat):

In einem 500 mL Rundkolben wurden 0,1 g 2,6-Di-tert.-butyl-4-methylphenol, 0,05 g Dibutylzinn-dilaurat (Desmorapid^{®} Z, Bayer MaterialScience AG, Leverkusen, Deutschland) sowie und 213.07 g einer 27 %-igen Lösung von Tris(p-isocyanatophenyl)thiophosphat in Ethylacetat (Desmodur^{®} RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0,1 % gesunken war. Danach wurde abgekühlt und im Vakuum das Ethylacetat vollständig entfernt. Das Produkt wurde als teilkristalliner Feststoff erhalten.

### Schreibmonomer 2 (2-({[3-(Methylsulfanyl)phenyl]carbamoyl}oxy)ethylprop-2-enoat):

In einem 100 mL Rundkolben wurden 0,02 g 2,6-Di-tert.-butyl-4-methylphenol, 0,01 g Desmorapid^{®} Z, 11.7 g 3-(Methylthio)phenylisocyanat vorgelegt und vorgelegt und auf 60 °C erwärmt. Anschließend wurden 8.2 g 2-Hydroxyethylacrylat zugetropft und die Mischung weiter auf 60 °C gehalten, bis der Isocyanatgehalt unter 0,1 % gesunken war. Danach wurde abgekühlt. Das Produkt wurde als hellgelbe Flüssigkeit erhalten.

### Additive 1 (Bis(2,2,3,3,4,4,5,5,6,6,7,7-dodecafluorheptyl)-(2,2,4-trimethylhexan-1,6-diyl)biscarbamat):

In einem 2000 mL Rundkolben wurden 0,02 g Desmorapid^{®} Z und 3,60 g 2,4,4-Trimethylhexane-1,6-diisocyanat (TMDI) vorgelegt und auf 70 °C erwärmt. Anschließend wurden 11,39 g 2,2,3,3,4,4,5,5,6,6,7,7-Dodecafluorheptan-1-ol zugetropft und die Mischung weiter auf 70 °C gehalten, bis der Isocyanatgehalt unter 0,1 % gesunken war. Danach wurde abgekühlt. Das Produkt wurde als farbloses Öl erhalten.

### Herstellung der Photopolymerfilme:

### Photopolymerfilm 1:

16,57 g Polyol 1 wurden schrittweise mit 7,50 g Schreibmonomer 1, 7,50 g Schreibmonomer 2 und 12,50 g Additiv 1, dann 0,050 g Katalysator 1 und 0,15 g Byk® 310, und zuletzt einer Lösung von 0,75 g CGI 909, 0,10 g Neu Methylenblau (als Tetraphenylborat), 0,050 g Safranin O (als Tetraphenylborat) und 0,050 g Astrazon Orange G (als Tetraphenylborat) in 1,705 g N-Ethylpyrilidon (zusammen Photoinitiator 1) im Dunkeln versetzt und gemischt, so dass eine klare Lösung erhalten wurde. Anschließend wurden bei 30 °C 3,070 g Komponente a) zugegeben und erneut gemischt. Die erhaltene, flüssige Masse wurde dann auf Substrat 1 appliziert und 4,5 Minuten bei 80°C getrocknet. Trockenschichtdicke: 16 µm.

### Photopolymerfilm 2:

16,57 g Polyol 1 wurden schrittweise mit 7,50 g Schreibmonomer 1, 7,50 g Schreibmonomer 2 und 12,50 g Additiv 1, dann 0,050 g Katalysator 1 und 0,15 g Byk^{®} 310, und zuletzt einer Lösung von 0,75 g CGI 909, 0,10 g Neu Methylenblau (als Tetraphenylborat), 0,050 g Safranin O (als Tetraphenylborat) und 0,050 g Astrazon Orange G (als Tetraphenylborat) in 1,705 g N-Ethylpyrilidon (zusammen Photoinitiator 1) im Dunkeln versetzt und gemischt, so dass eine klare Lösung erhalten wurde. Anschließend wurden bei 30 °C 3,070 g Komponente a) zugegeben und erneut gemischt. Die erhaltene, flüssige Masse wurde dann auf Substrat 2 appliziert und 4,5 Minuten bei 80 °C getrocknet. Trockenschichtdicke: 23µm.

### Photopolymerfilm 3:

6,63 g Polyol 1 wurden schrittweise mit 3,50 g Schreibmonomer 1, 3,50 g Schreibmonomer 2 und 4,00 g Additiv 1, dann 0,020 g Katalysator 1 und 0,060 g Byk^{®} 310, und zuletzt einer Lösung von 0,30 g CGI 909, 0,040 g Neu Methylenblau (als Dodecylbenzolsulfonat), 0,020 g Safranin O (als Dodecylbenzolsulfonat) und 0,020 g Astrazon Orange G (als Dodecylbenzolsulfonat) in 0,682 g N-Ethylpyrilidon (zusammen Photoinitiator 1) im Dunkeln versetzt und gemischt, so dass eine klare Lösung erhalten wurde. Anschließend wurden bei 30 °C 1,228 g Komponente a) zugegeben und erneut gemischt. Die erhaltene, flüssige Masse wurde dann auf Substrat 2 appliziert und 4,5 Minuten bei 80 °C getrocknet. Trockenschichtdicke: 15,5µm.

### Photopolymerfilm 4:

6,63 g Polyol 1 wurden schrittweise mit 3,50 g Schreibmonomer 1, 3,50 g Schreibmonomer 2 und 4,00 g Additiv 1, dann 0,020 g Katalysator 1 und 0,060 g Byk^{®} 310, und zuletzt einer Lösung von 0,30 g CGI 909, 0,040 g Neu Methylenblau (als Dodecylbenzolsulfonat), 0,020 g Safranin O (als Dodecylbenzolsulfonat) und 0,020 g Astrazon Orange G (als Dodecylbenzolsulfonat) in 0,682 g N-Ethylpyrilidon (zusammen Photoinitiator 1) im Dunkeln versetzt und gemischt, so dass eine klare Lösung erhalten wurde. Anschließend wurden bei 30 °C 1,228 g Komponente a) zugegeben und erneut gemischt. Die erhaltene, flüssige Masse wurde dann auf Substrat 1 appliziert und 4,5 Minuten bei 80 °C getrocknet. Trockenschichtdicke: 17µm.

### Photopolymerfilm 5:

397,2 g Polyol 1 wurden schrittweise mit 195,0 g Schreibmonomer 1, 195,0 g Schreibmonomer 2 und 270,0 g Additiv 1, dann 0,84 g Katalysator 2 und 3,60 g Byk^{®} 310, und zuletzt einer Lösung von 18,0 g CGI 909, 2,4 g Neu Methylenblau (als Dodecylbenzolsulfonat), 1,2 g Safranin O (als Dodecylbenzolsulfonat) und 1,2 g Astrazon Orange G (als Dodecylbenzolsulfonat) in 42,0 g N-Ethylpyrilidon (zusammen Photoinitiator 1) im Dunkeln versetzt und gemischt, so dass eine klare Lösung erhalten wurde. Anschließend wurden bei 30 °C 73,57 g Komponente a) zugegeben und erneut gemischt. Die erhaltene, flüssige Masse wurde dann auf Substrat 1 appliziert und 4,5 Minuten bei 80 °C getrocknet. Trockenschichtdicke: 23µm.

### Holographische Belichtung der Photopolymerfilme:

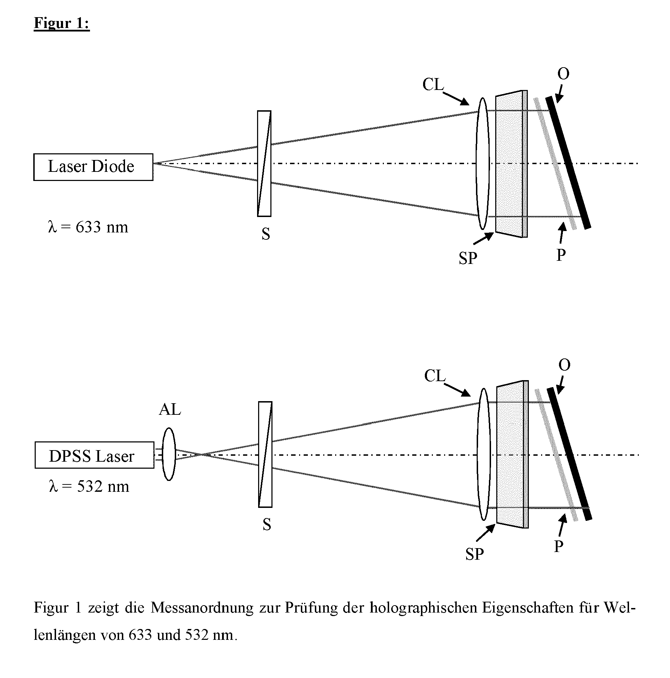

In den Photopolymerfilm wurde ein Hologramm mittels einer Messanordnung gemäß Figur 1 einbelichtet. Es handelte sich um monochromatische Hologramme mit 633 nm oder 532 nm Laserwellenlänge. Dazu wurden Stücke des Filmes im Dunkeln abgeschnitten, die Kaschierfolie entfernt und die Filme mit der Photopolymerseite nach unten auf ein Glas der Größe 50 x 75 mm und Dicke 1 mm blasenfrei laminiert. Als Gläser wurden Corning Gläser der Firma Schott AG, Mainz, Deutschland verwendet.

Der Strahl eines Lasers (Emissionswellenlänge 633 nm oder 532 nm) wurde mit Hilfe einer optionalen Aufweitungslinse (AF) und der Kollimationslinse (CL), die nach dem Shutter S platziert ist auf einen Durchmesser von - 3 - 4 cm aufgeweitet. Der Durchmesser des aufgeweiteten Laserstrahls wurde dabei durch die Apertur des geöffneten Shutters bestimmt. Es wurde bewusst auf eine inhomogene Intensitätsverteilung des aufgeweiteten Laserstrahles geachtet. So betrug die Randintensität PR - nur die Hälfte der Intensität PZ im Zentrum des aufgeweiteten Laserstrahls. P war hier als Leistung/ Fläche zu verstehen. Der aufgeweitete Laserstrahl durchlief zunächst eine schräg zum Strahl gestellte Glasplatte, die als Shearing Plate (SP) diente. Anhand des nach oben gespiegelten Interferenzmusters, das von den zwei Glasoberflächenreflexen der SP erzeugt wurde, konnte erkannt werden, ob der Laser stabil im Single Mode emittiert. Dann war auf einer über der SP platziert Mattscheibe ein Muster aus dunklen und hellen Streifen zu sehen. Nur wenn Single Mode Emission gegeben war, wurden holographischen Belichtungen durchgeführt. Im Falle der DPSS Laser konnte der Single Mode durch einstellen des Pumpstroms erreicht werden. Der aufgeweitete Strahl durchlief den etwa 15° schräg gestellten Photopolymerfilm (P), dieser Teil bildete den Referenzstrahl, um dann vom zu P parallel angeordneten Objekt (O) wieder zurück in P reflektiert zu werden. Dieser Teil bildete dann den Signalstrahl der Denisyukanordnung.

Die Interferenz von Signal- und Referenzstrahl in P erzeugte das Hologramm im Photopolymerfilm. O bestand aus einer mit weißem Papier bedeckten Metallplatte, wobei die Papierseite P zugewandt war. Auf dem Papier befand sich ein quadratisches Raster erzeugt durch schwarze Linien. Die Kantenlänge eines Quadrates betrug 0.5 cm. Dieses Raster wurde bei der holographischen Belichtung von P mit im Hologramm abgebildet.

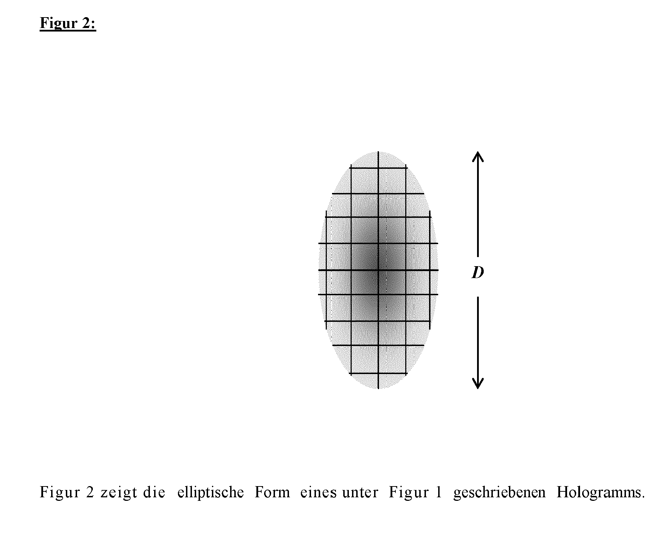

Die mittlere Belichtungsdosis Eave wurde durch die Öffnungszeit t von S eingestellt. Bei fixierter Laserleistung I stellte t daher die zu Eave proportionale Größe dar. Da der aufgeweitete Laserstrahl eine inhomogenene (glockenförmige) Intensitätsverteilung besaß, variiert die lokale Dosis E zur Erzeugung des Hologramms in P. Dies führt, zusammen mit der Schrägstellung von P und O zur optischen Achse dazu, dass das geschriebene Hologramm elliptische Form besaß. Dies ist in Figur 2 dargestellt.

Da es sich bei O um einen diffusen Reflektor handelte, war das Hologramm durch Beleuchten mit einer Punktlichtquelle (z. B. Taschenlampe oder LED-Leuchte) leicht zu rekonstruieren.

Nach dem Einbelichten des Hologramms wurde der Photopolymerfilm weiterhin auf Glas laminiert und unter UV-Strahlung geblichen. Dazu wurden die Proben aus einer lichtecht verpackten Aluminiumtüte mit der Glasseite nach oben auf das Förderband einer UV-Anlage gelegt und mit einer Bandgeschwindigkeit von 2,5 m/min zweimal unter einer Lampe des Typs Fusion UV 558434 KR 85 mit einer nominalen Leistungsdichte von 80 W/cm² mit einer Energiedichte auf dem Photopolymer von ca. 2 J/cm² belichtet.

### Verwendete Klebstoffprodukte zur Herstellung der Klebstoffschichten:

Klebstoff 1 ist ein Klebeband mit dem Produktcode C 114 der Aslan, Schwarz GmbH & Co. KG, Overath, Deutschland (Typ: acrylat-basiertes Haftklebeband).
Klebstoff 2 ist ein Transferklebeband mit dem Produktcode Scotch K 9485 der 3M Deutschland GmbH, Neuss, Deutschland (Typ: Haftklebeband auf Basis modifizierter Acrylate).
Klebstoff 3 ist ein Transferklebeband mit dem Produktcode Scotch 9482 PC der 3M Deutschland GmbH, Neuss, Deutschland (Typ: Haftklebeband auf Basis modifizierter Acrylate).
Klebstoff 4 ist Levamelt® 700 der LANXESS Deutschland GmbH (Typ: Schmelzklebstoff auf Basis Poly(ethylen-co-vinylacetat).
Klebstoff 5 ist Platilon HU2 der Epurex Films GmbH & Co. KG, Walsrode, Deutschland (Typ: Schmelzfolie auf Basis thermoplastischen Polyurethan).
Klebstoff 6 ist CoPET VA 334 080/09; experimentelles Produkt der Epurex Films GmbH & Co. KG, Walsrode, Deutschland (Typ: Schmelzfolie auf Basis Copolyester).
Klebstoff 7 ist MXCur 350 der CarTell UK Ltd., Corby, Großbritannien (Typ: UV-härtender Flüssigklebstoff auf Basis von Acrylaten).
Klebstoff 8 ist Araldite 2026 A der Huntsman Advanced Materials (Europe) BVBA, Everberg, Belgien (zweikomponentiger Flüssigklebstoff auf Basis von Polyurethanen)
Klebstoff 9 ist ein Klebeband mit dem Produktcode S11.628 der nolax AG, Sempach-Station, Schweiz (Typ: kautschuk-basiertes Haftklebeband).
Klebstoff 10 ist ein Transferklebeband mit dem Produktcode Vito 4050 der VITO Irmen GmbH & Co. KG, Remagen, Deutschland (Typ: Haftklebeband auf Kautschukbasis).
Klebstoff 11 ist ein Klebeband mit dem Produktcode AF 24.449 der AF Adhäsive Formteile GmbH, Pfinztal, Deutschland (Typ: silicon-basiertes Haftklebeband).
Klebstoff 12 ist ein Versuchsprodukt der Bayer MaterialScience AG, Leverkusen, Deutschland, Dispercoll C VP LS 2372-1, Flüssigklebstoffdispersion auf Basis Chloropren.
Klebstoff 13 ist eine Mischung aus 90 Gew.-% Desmolux U 100 und 10 Gew.-% Desmolux VP LS 2396, Flüssigklebstoff auf Basis von Urethanacrylaten, Versuchsprodukte der Bayer MaterialScience AG, Leverkusen, Deutschland.
Klebstoff 14 ist ein Klebeband mit dem Produktcode E5016C-DACH der 3M, St. Paul (Minnesota), USA (Typ: Haftklebeband auf Basis Synthesekautschuk).
Klebstoff 15 ist Oppanol® B 15 SFN der BASF SE, Ludwigshafen, Deutschland (Typ: Schmelzklebstoff auf Basis Poly(isobutylen)).
Klebstoff 16 ist ein Schmelzklebstoff mit dem Produktcode D41544 der Bühnen GmbH & Co. KG, Bremen, Deutschland (Typ: Schmelzklebstoff auf Polyolefinbasis).
Klebstoff 17 ist WK-20 der Wekem GmbH, Werne, Deutschland (Typ: Flüssigklebstoff auf Basis von Cyanacrylaten).
Klebstoff 18 ist Cyberbond 2006 der Cyberbond Europe GmbH, Wunstorf, Deutschland (Typ: Flüssigklebstoff auf Basis von Cyanacrylaten).
Klebstoff 19 ist eine Mischung aus 59,3 Gew.-% Desmodur N 3800 und 40,7 Gew.-% Desmophen 1100, Flüssigklebstoff auf Basis von 2K-Polyurethan, Handelsprodukte der Bayer MaterialScience AG, Leverkusen, Deutschland.
Klebstoff 20 ist Parker IA 25 der Parker Hannifin GmbH, Pleidelsheim, Deutschland (Typ: Flüssigklebstoff auf Basis von Cyanacrylaten).

### Aufbringen der Klebstoffschichten:

Auf die belichteten Photopolymerfilme wurden verschiedene Klebstoffschichten aufgebracht. Folgende Verfahren wurden verwendet:
i) Direktes Verbinden mit Klebstoff / Klebefolien, Aufbringen entweder durch Handroller oder von Hand.
ii) Aufbringen einer Schicht einer flüssigen Klebstoffmischung auf ein Substrat, mit dem der Photopolymerfilm verbunden werden soll. Direkt im Anschluss wird der Photopolymerfilm auf die Klebstoffschicht aufgebracht und bei erhöhter Temperatur und/ oder durch UV-Strahlung getrocknet/ gehärtet. Die Aufbringung kann durch Verteilen mit einem Handrakel oder mit einem automatischen Rakel erfolgen.
iii) Aufbringen einer flüssigen Klebstoffmischung auf die Fläche/ Folie, auf die verklebt wurde, Trocknung bei 80°C. Die Aufbringung kann durch Verteilen mit einem Handrakel oder mit einem automatischen Rakel erfolgen. Nach der Trocknung wird die Photopolymerschicht mit einem Laminiergerät oder einer Presse mit geeigneten Druck/ Temperatur in Kontakt gebracht und verpresst.
iv) direkte Verklebung mit Klebefolien bei erhöhter Temperatur mit einem Rollenlaminator oder einer Presse bei geeignetem Druck.

Nach Lagerung von 7 Tagen bei Raumtemperatur und 3 Tagen bei 60 °C nach der Verklebung wurde die Farbveränderung im Hologramm mit bloßem Auge unter geeigneter Beleuchtung durch monochromatische LED (rot, grün, blau), Weißlicht-LED oder Halogenlampe beurteilt.

| Beispiel | Klebstoff | Applikationsverfahren | Farbshift | ATR-IR-Messung zeitabhängige Änderung des Absorptionsspektrums |
|---|---|---|---|---|
| V1 | 1 | i) | ja | - |
| V2 | 2 | i) | ja | ja |
| V3 | 3 | i) | ja | ja |
| V4 | 4 | iii) | ja | - |
| V5 | 5 | iv) | ja | - |
| V6 | 7 | ii) | ja | - |
| V7 | 19 | ii) | ja | ja |
| 1 | 6 | iv) | nein | - |
| 2 | 8 | ii) | nein | nein |
| 3 | 9 | i) | nein | - |
| 4 | 10 | i) | nein | nein |
| 5 | 11 | i) | nein | - |
| 6 | 12 | iii) | nein | - |
| 7 | 13 | ii) | nein | nein |
| 8 | 14 | i) | nein | - |
| 9 | 15 | iii) | nein | nein |
| 10 | 16 | iii) | nein | nein |
| 11 | 17 | ii) | nein | - |
| 12 | 18 | ii) | nein | - |
| 13 | 20 | ii) | nein | nein |

Die erfindungsgemäßen Schichtverbünde der Bespiele 1 bis 13 zeigten keine Wellenlängenverschiebung von mehr als 20 nm, d.h. es war kein Farbshift zu beobachten. Im Gegensatz hierzu war bei den Schichtverbünden der Vergleichsbeispiele V1 bis V7 ein deutlicher Farbshift zu beobachten.

Bei den erfindungsgemäßen Schichtverbünden wirkte die Klebstoffschicht als Diffusionsbarriere für das Fluorurethan-Additiv C). Dies wurde durch entsprechende beispielhafte ATR-IR-Messungen belegt.

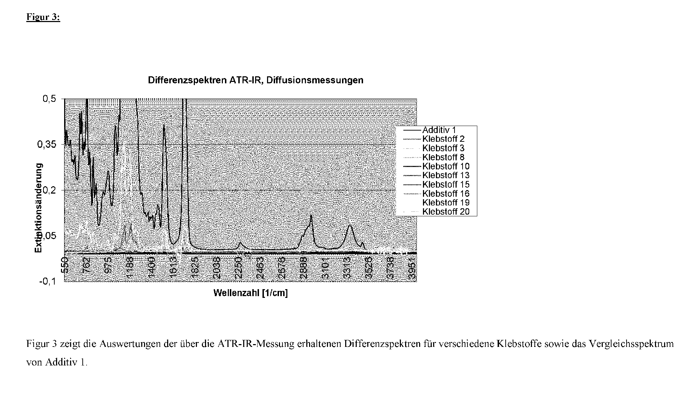

Figur 3 zeigt die erhaltenen Differenzspektren. Bei den erfindungsgemäßen Klebstoffschichten traten während der Messdauer keine Peaks im Differenzspektrum von einer Extinktionsänderung von > 3,2 % auf.

## Patentansprüche

1. Schichtverbund umfassend einen belichteten Photopolymerfilm und eine zumindest bereichsweise mit dem Photopolymerfilm verbundene Klebstoffschicht, wobei der Photopolymerfilm vernetzte Polyurethan-Matrixpolymere A), vernetzte Schreibmonomere B) und ein monomeres Fluorurethan-Additiv C) umfasst, **dadurch gekennzeichnet, dass** die Klebstoffschicht als Diffusionsbarriere für das Fluorurethan-Additiv C) ausgebildet ist.

2. Schichtverbund nach Anspruch 1, **dadurch gekennzeichnet, dass** die Klebstoffschicht so ausgebildet ist, dass bei einer ATR-IR-Messung keine zeitabhängige Änderung des Absorptionsspektrums auftritt, wenn die die Klebstoffschicht mit dem Fluorurethan-Additiv C) benetzt wird.

3. Schichtverbund nach einem der Ansprüche 1 oder 2, **dadurch gekennzeichnet, dass** die Klebstoffschicht wenigstens eine Verbindung ausgewählt aus der Gruppe Synthesekautschuke, Chloroprenkautschuke, polyesterbasierte Schmelzklebstoffe, silicon-basierte Klebstoffe, urethan-basierte Klebstoffe hoher Netzwerkdichte, gegebenenfalls mit zusätzlichen strahlenhärtenden Gruppen oder basierend auf Urethanacrylaten, polyolefin-basierte Klebstoffe und Cyanacrylatklebstoffe umfasst oder daraus besteht und besonders bevorzugt wenigstens eine Verbindung ausgewählt aus der Gruppe Synthesekautschuke, polyesterbasierte Schmelzklebstoffe, urethan-basierte Klebstoffe enthaltend Urethanacrylate und Cyanacrylatklebstoffe umfasst oder daraus besteht.

4. Schichtverbund nach einem der Ansprüche 1 bis 3, **dadurch gekennzeichnet, dass** das Fluorurethan-Additiv C) wenigstens eine Verbindung der Formel (I) 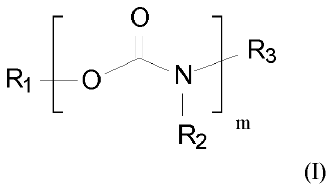 enthält oder daraus besteht, in der m≥1 und m≤8 ist und R1, R2, R3 unabhängig voneinander Wasserstoff, lineare, verzweigte, cyclische oder heterocyclische unsubstituierte oder gegebenenfalls auch mit Heteroatomen substituierte organische Reste sind, wobei bevorzugt mindestens einer der Reste R1, R2, R3 mit wenigstens einem Fluoratom substituiert ist und besonders bevorzugt R1 ein organischer Rest mit mindestens einem Fluoratom ist.

5. Schichtverbund nach einem der Ansprüche 1 bis 4, **dadurch gekennzeichnet, dass** der Photopolymerfilm zusätzlich einen Photoinitiator D) und / oder einen Katalysator E) umfasst.

6. Schichtverbund nach einem der Ansprüche 1 bis 5, **dadurch gekennzeichnet, dass** die Schreibmonomere B) photochemisch vernetzte Acrylate sind.

7. Schichtverbund nach einem der Ansprüche 1 bis 6, **dadurch gekennzeichnet, dass** die Klebstoffschicht eine Dicke im Bereich von 3 bis 100 µm, bevorzugt von 10 bis 75 µm und besonders bevorzugt von 15 bis 55 µm aufweist.

8. Schichtverbund nach einem der Ansprüche 1 bis 7, **dadurch gekennzeichnet, dass** die Polyurethan-Matrixpolymere A) durch Umsetzung von Polyisocyanaten a) und Polyolen b) erhältlich sind.

9. Schichtverbund nach einem der Ansprüche 1 bis 8, **dadurch gekennzeichnet, dass** in den Photopolymerfilm ein Hologramm einbelichtet ist.

10. Schichtverbund nach einem der Ansprüche 1 bis 9, **dadurch gekennzeichnet, dass** die Klebstoffschicht vollflächig mit dem Photopolymerfilm verbunden ist.

11. Schichtverbund nach einem der Ansprüche 1 bis 10, **dadurch gekennzeichnet, dass** er zusätzlich wenigstens eine Abdeckschicht aufweist, die insbesondere lösbar mit der Klebstoffschicht verbunden sein kann.

12. Verwendung eines Schichtverbunds nach einem der Ansprüche 1 bis 11 zur Herstellung von Chipkarten, Ausweisdokumenten oder 3D-Bildern, als Produktschutzetikett, als Label, in Banknoten in Form eines Streifens oder Fensters oder als holografisch optische Elemente in Displays.
